# EUROPEAN PATENT APPLICATION

(11) **EP 2 934 075 A1**
(43) Date of publication of application: **21.10.2015**
(21) Application number: 13862412.7
(22) Date of filing: 11.09.2013
(51) Int. Cl.: H05K 3/46

(54) **MULTILAYER WIRING SUBSTRATE AND PRODUCTION METHOD THEREFOR**

(30) Priority: 12.12.2012 JP 2012271443
(71) Applicant: NGK Spark Plug Co., Ltd., Nagoya-shi, Aichi 467-8525 (JP)
(72) Inventor: MAEDA, Shinnosuke, Nagoya-shi Aichi 467-8525 (JP)
(74) Representative: Intès, Didier Gérard André
(86) International application number: PCT/JP2013/005365
(87) International publication number: WO 2014/091644

(57) **Abstract**

To improve the degree of freedom of design of a multilayer wiring substrate incorporating therein an electronic component. A multilayer wiring substrate 1 includes a first layered structure including conductor layers 13, 14, 15, and 16, and insulation layers 23, 24, 25, and 26 including therein via conductors 33, 34, 35, and 36 each having a diameter which decreases from the upper surface of the insulation layer toward the lower surface thereof; an electronic component 51 embedded in the first layered structure; and a second layered structure stacked on the first layered structure, and including conductor layers 17 and 18, and an insulation layer 27 including therein a via conductor 37 having a diameter which decreases from the upper surface of the insulation layer toward the lower surface thereof.

## Description

### TECHNICAL FIELD

The present invention relates to a multilayer wiring substrate having a structure in which a plurality of insulation layers and a plurality of conductor layers are alternately stacked, and to a method for producing the multilayer wiring substrate.

### BACKGROUND ART

Hitherto, there has been known a technique for providing a hole in a front-surface portion of a multilayer wiring substrate including a plurality of insulation layers and a plurality of conductor layers, the insulation layers and the conductor layers being alternately stacked, so that the hole penetrates the insulation layers, and accommodating an electronic component in the hole so that the electronic component is incorporated into the multilayer wiring substrate (see, for example, Patent Document 1).

### PRIOR ART DOCUMENT

### PATENT DOCUMENT

Patent Document 1: Japanese Patent Application Laid-Open (*kokai*) No. 2012-99610

### SUMMARY OF THE INVENTION

### PROBLEMS TO BE SOLVED BY THE INVENTION

However, in the case of the technique described in Patent Document 1, a region for incorporation of an electronic component is limited to a portion near the front surface of the wiring substrate, which may reduce the degree of freedom of design of the wiring substrate (e.g., wiring layout in the wiring substrate).

In view of the foregoing, an object of the present invention is to improve the degree of freedom of design of a multilayer wiring substrate incorporating therein an electronic component.

### MEANS FOR SOLVING THE PROBLEMS

In order to achieve the aforementioned object, the present invention provides a multilayer wiring substrate comprising a plurality of insulation layers and a plurality of conductor layers, the insulation layers and the conductor layers being alternately stacked, and a via conductor formed in each insulation layer for electrically connecting conductor layers formed on upper and lower surfaces of the insulation layer, the multilayer wiring substrate being characterized by comprising a first layered structure including a plurality of conductor layers, and a plurality of insulation layers each including therein a via conductor having a diameter which decreases from the upper surface of the insulation layer toward the lower surface thereof; an electronic component embedded in the first layered structure; and a second layered structure stacked on the first layered structure, and including at least one conductor layer, and at least one insulation layer including therein a via conductor having a diameter which decreases from the upper surface of the insulation layer toward the lower surface thereof.

According to the multilayer wiring substrate with this configuration, the electronic component is embedded in the first layered structure, and the second layered structure, which includes at least one insulation layer and at least one conductor layer, is stacked on the first layered structure. Thus, when the number of insulation layers forming the second layered structure is small, the embedded electronic component is located in a region near the upper surface of the multilayer wiring substrate. Meanwhile, when the number of insulation layers forming the second layered structure is large, the embedded electronic component is located in a region away from the upper surface of the multilayer wiring substrate.

Therefore, according to the multilayer wiring substrate of the present invention, since a region for incorporation of the electronic component is not limited to a portion near the upper surface of the multilayer wiring substrate, the degree of freedom of design can be improved.

In the multilayer wiring substrate of the present invention, the first layered structure may include a metal layer which is formed below the electronic component so as to be in contact with a lower portion of the electronic component.

According to the multilayer wiring substrate with this configuration, since heat generated in the electronic component is conducted to the metal layer and released to the outside of the electronic component, the heat release performance of the electronic component can be improved.

In the multilayer wiring substrate of the present invention, a plurality of electronic components may be embedded in the first layered structure, and the electronic components may be located at different positions on a plane perpendicular to a stacking direction of the first layered structure.

According to the multilayer wiring substrate with this configuration, the positions of the electronic components embedded in the first layered structure are not limited to a specific one position on a plane perpendicular to the stacking direction of the first layered structure. Therefore, the degree of freedom of the positions of the electronic components incorporated in the multilayer wiring substrate can be improved.

In the multilayer wiring substrate of the present invention, one electronic component of the electronic components embedded in the first layered structure may be defined as a first electronic component; another electronic component different from the first electronic component may be defined as a second electronic component; among the insulation layers forming the first layered structure, an insulation layer which does not have the first electronic component embedded therein may be defined as a non-embedded insulation layer; and the second electronic component may also be embedded in the non-embedded insulation layer.

According to the multilayer wiring substrate with this configuration, since a wire can be formed in the non-embedded insulation layer at a region facing the first electronic component in the aforementioned stacking direction, wiring density can be improved in the non-embedded insulation layer.

In the multilayer wiring substrate of the present invention, the via conductor may be connected to an upper portion of the electronic component, and the via conductor may have a length in the stacking direction of the first layered structure greater than that of the insulation layer through which the via conductor penetrates.

According to the multilayer wiring substrate with this configuration, when an upper portion of the electronic component is embedded in a first insulation layer, and a second insulation layer is stacked on the first insulation layer, the via conductor penetrates the second insulation layer, extends in the first insulation layer, and is connected to the electronic component. Therefore, the via conductor may be formed through a process in which the second insulation layer is stacked on the first insulation layer, and then a via hole is provided so as to penetrate the second insulation layer, to extend in the first insulation layer, and to reach the electronic component. That is, there is no requirement to carry out a process in which a first via conductor is formed after formation of the first insulation layer, and then a second via conductor is formed after formation of the second insulation layer. Thus, a process of forming the via conductor can be simplified.

In the multilayer wiring substrate of the present invention, a glass fiber layer may be provided in the first layered structure, and the electronic component may be embedded so as to penetrate the glass fiber layer. Thus, the rigidity of a portion in which the electronic component is embedded (i.e., the first layered structure) can be enhanced in the multilayer wiring substrate.

In the multilayer wiring substrate of the present invention, the first layered structure may have therein an accommodation hole for accommodating the electronic component in the first layered structure, the accommodation hole being provided before embedment of the electronic component in the first layered structure, and the accommodation hole may have a diameter which decreases downwardly. Thus, the area of the opening of the accommodation hole is larger than that of the bottom thereof. Therefore, the electronic component can be readily accommodated into the accommodation hole through the opening thereof, and the electronic component can be reliably mounted in the multilayer wiring substrate.

In order to achieve the aforementioned object, the present invention also provides a method for producing a multilayer wiring substrate comprising a plurality of insulation layers and a plurality of conductor layers, the insulation layers and the conductor layers being alternately stacked, and a via conductor formed in each insulation layer for electrically connecting conductor layers formed on upper and lower surfaces of the insulation layer, the method being characterized by comprising a first layered structure formation step of forming a first layered structure including a plurality of conductor layers, and a plurality of insulation layers each including therein a via conductor having a diameter which decreases from the upper surface of the insulation layer toward the lower surface thereof; a metal layer formation step of forming a metal layer in a region in the first layered structure in which an electronic component is to be embedded, the metal layer formation step being carried out during the course of the first layered structure formation step; an accommodation hole provision step of applying a laser beam via an upper surface of the first layered structure toward the metal layer in the first layered structure, to thereby provide an accommodation hole which extends in a stacking direction of the first layered structure to the metal layer, and which does not penetrate the metal layer; an accommodation step of accommodating an electronic component in the accommodation hole; and an insulation layer stacking step of stacking an insulation layer on the first layered structure after accommodation of the electronic component in the accommodation hole.

This production method is employed for producing the multilayer wiring substrate of the present invention. When this method is carried out, there can be obtained effects similar to those of the multilayer wiring substrate of the present invention.

The accommodation hole which extends to the metal layer but does not penetrate therethrough is formed through application of a laser beam toward the metal layer in the first layered structure. Therefore, the depth of the accommodation hole can be accurately controlled with respect to the position at which the metal layer is formed.

Since the electronic component is accommodated in the accommodation hole after provision thereof, the electronic component is embedded so that a lower portion thereof comes into contact with the metal layer. Therefore, heat generated in the electronic component is conducted to the metal layer and released to the outside of the electronic component, and the heat release performance of the electronic component can be improved.

In the case where heat generated in the electronic component is not required to be released via the metal layer, in the multilayer wiring substrate production method of the present invention, there may be carried out a removal step of removing the metal layer after provision of the accommodation hole and before accommodation of the electronic component in the accommodation hole.

### BRIEF DESCRIPTION OF THE DRAWINGS

[FIG. 1]

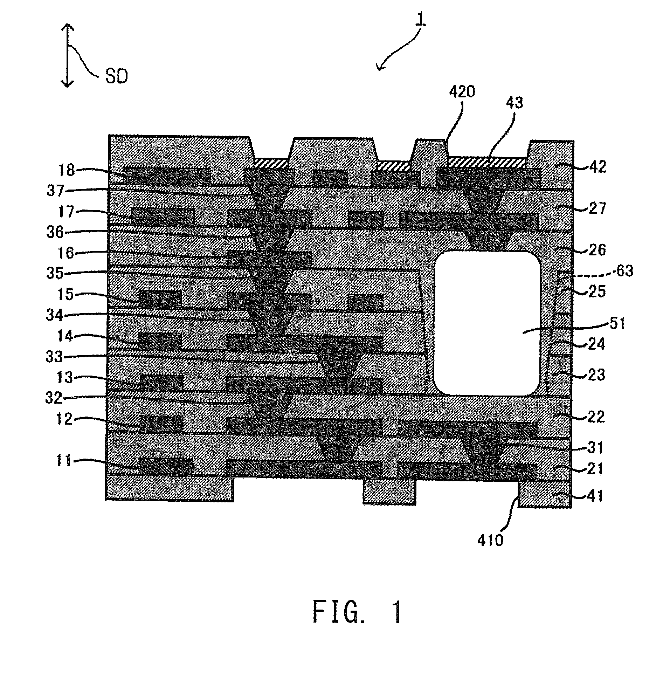

   FIG. 1 is a schematic cross-sectional view of the configuration of a multilayer wiring substrate 1 of a first embodiment.
[FIG. 2]

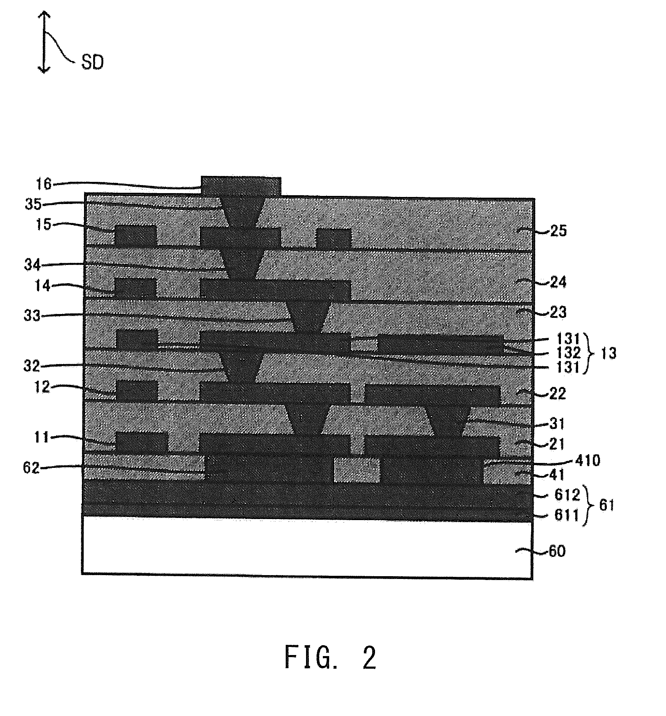

   FIG. 2 shows a process of producing the multilayer wiring substrate 1 of the first embodiment (first cross-sectional view).
[FIG. 3]

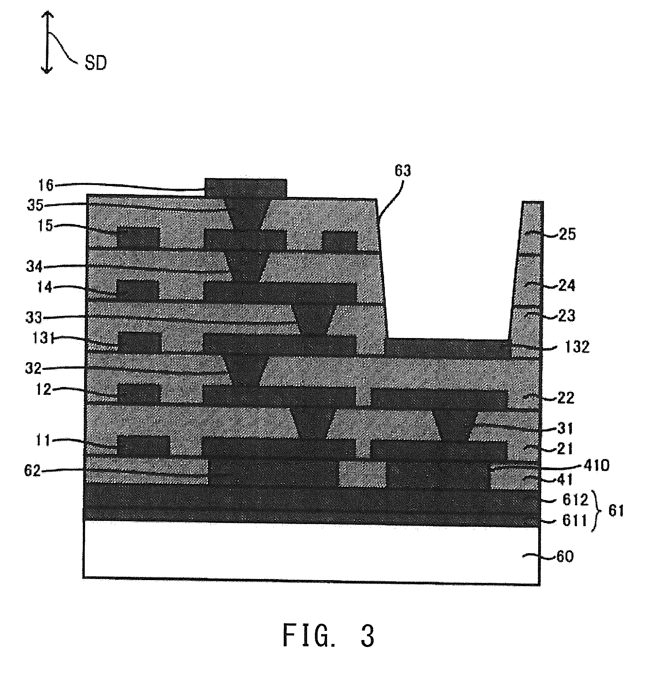

   FIG. 3 shows the process of producing the multilayer wiring substrate 1 of the first embodiment (second cross-sectional view).
[FIG. 4]

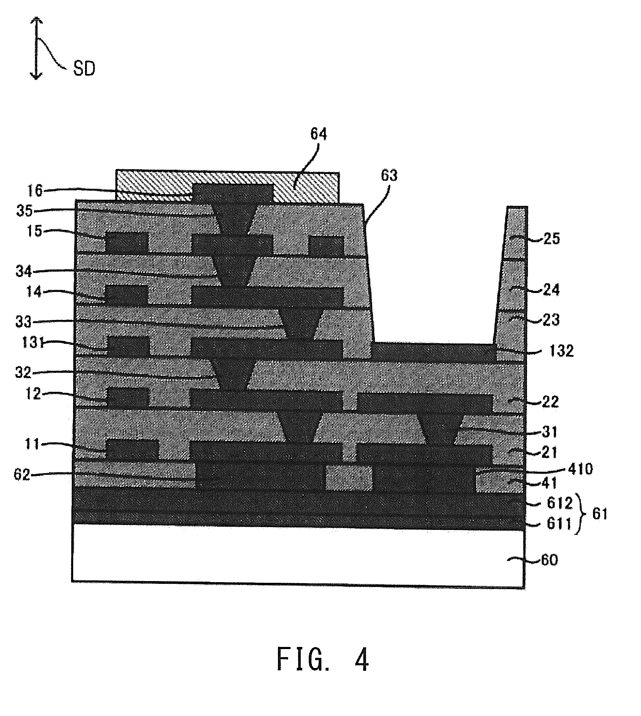

   FIG. 4 shows the process of producing the multilayer wiring substrate 1 of the first embodiment (third cross-sectional view).
[FIG. 5]

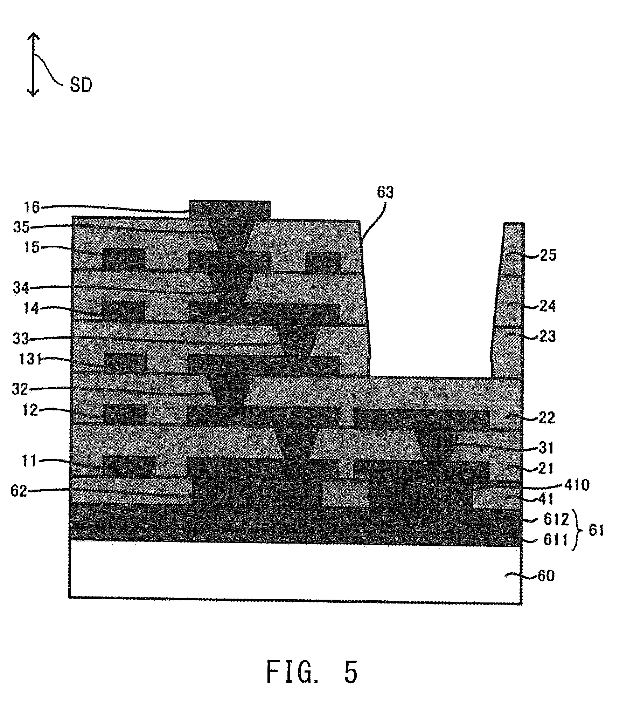

   FIG. 5 shows the process of producing the multilayer wiring substrate 1 of the first embodiment (fourth cross-sectional view).
[FIG. 6]

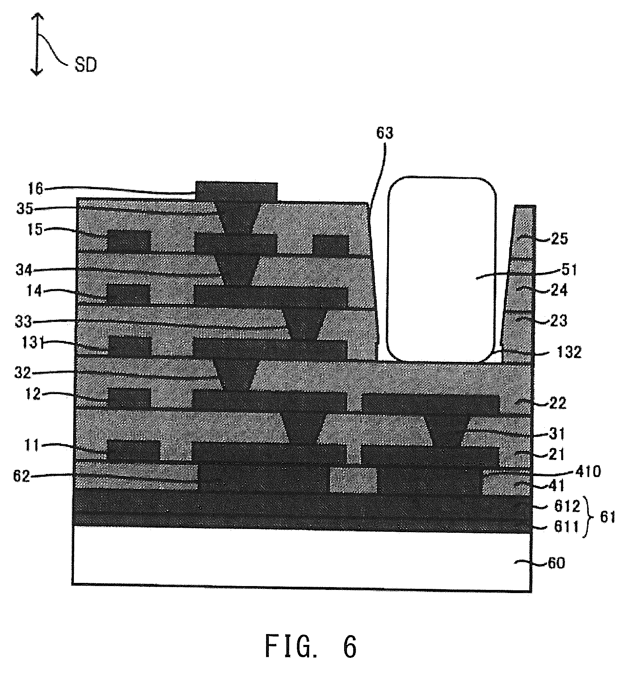

   FIG. 6 shows the process of producing the multilayer wiring substrate 1 of the first embodiment (fifth cross-sectional view).
[FIG. 7]

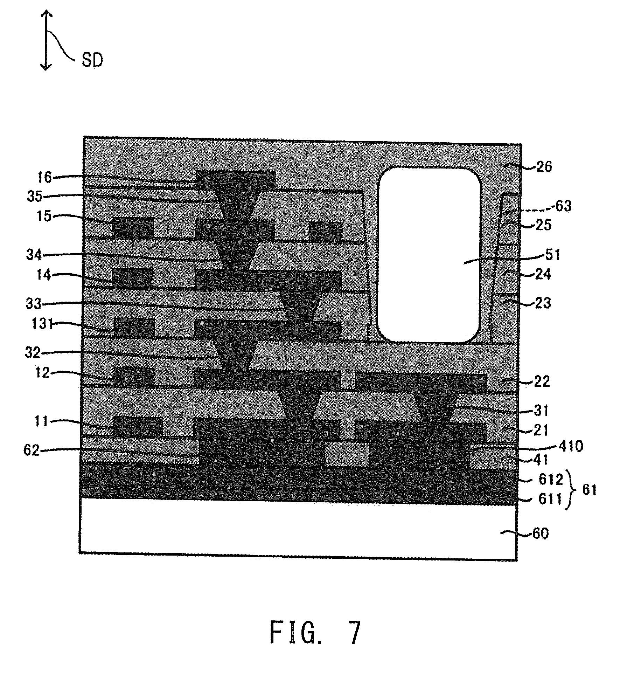

   FIG. 7 shows the process of producing the multilayer wiring substrate 1 of the first embodiment (sixth cross-sectional view).
[FIG. 8]

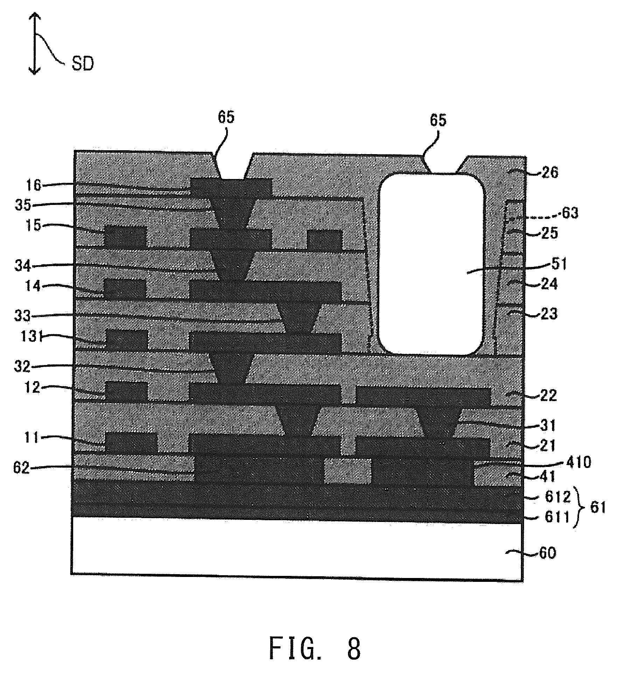

   FIG. 8 shows the process of producing the multilayer wiring substrate 1 of the first embodiment (seventh cross-sectional view).
[FIG. 9]

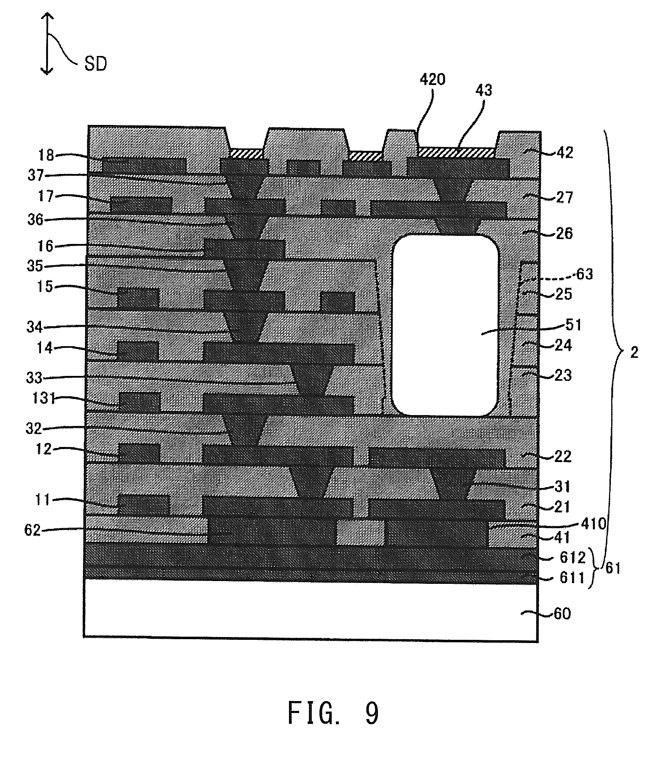

   FIG. 9 shows the process of producing the multilayer wiring substrate 1 of the first embodiment (eighth cross-sectional view).
[FIG. 10]

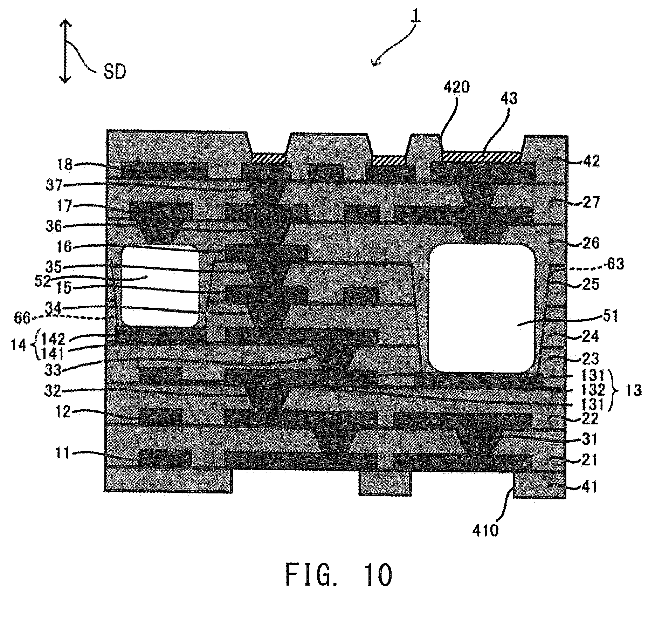

   FIG. 10 is a schematic cross-sectional view of the configuration of a multilayer wiring substrate 1 of a second embodiment.
[FIG. 11]

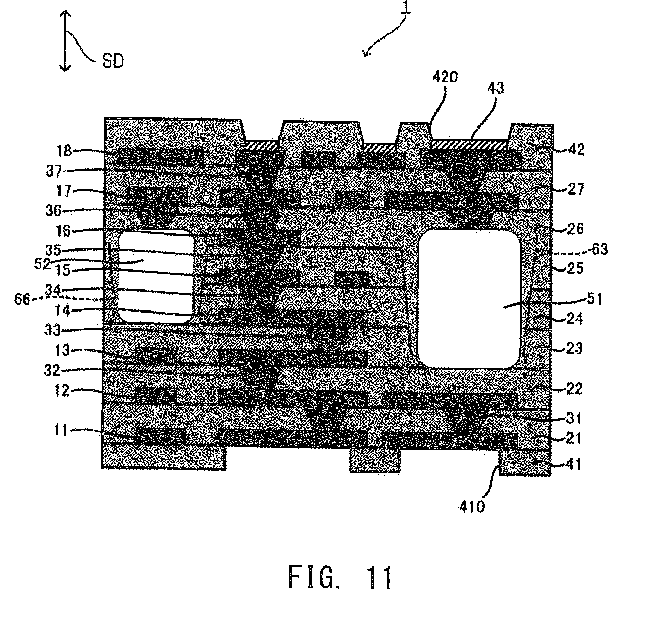

   FIG. 11 is a schematic cross-sectional view of the configuration of a multilayer wiring substrate 1 of a third embodiment.
[FIG. 12]

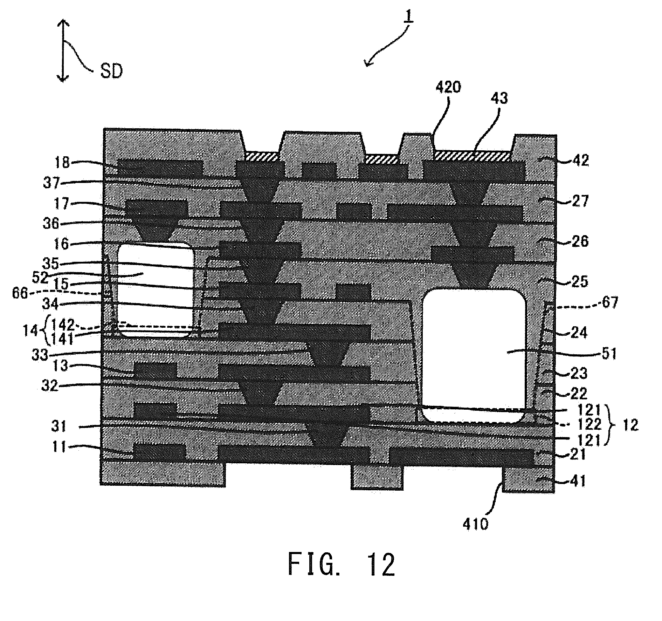

   FIG. 12 is a schematic cross-sectional view of the configuration of a multilayer wiring substrate 1 of a fourth embodiment.
[FIG. 13]

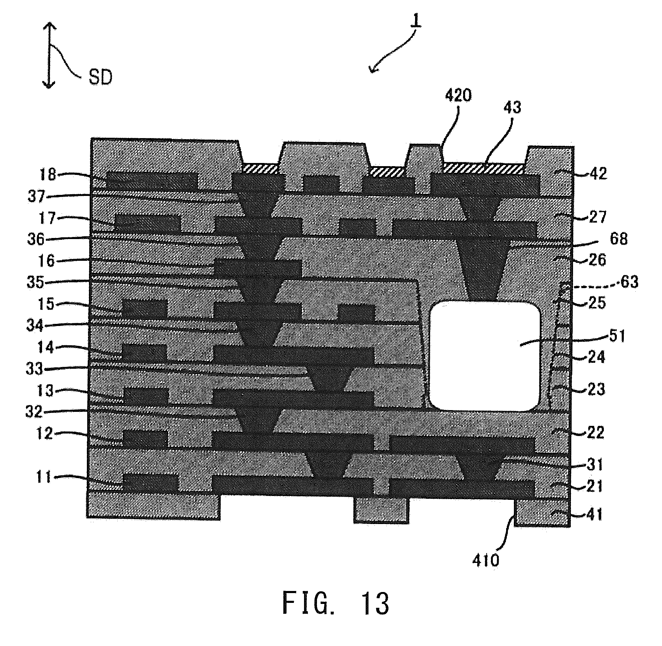

   FIG. 13 is a schematic cross-sectional view of the configuration of a multilayer wiring substrate 1 of a fifth embodiment.
[FIG. 14]

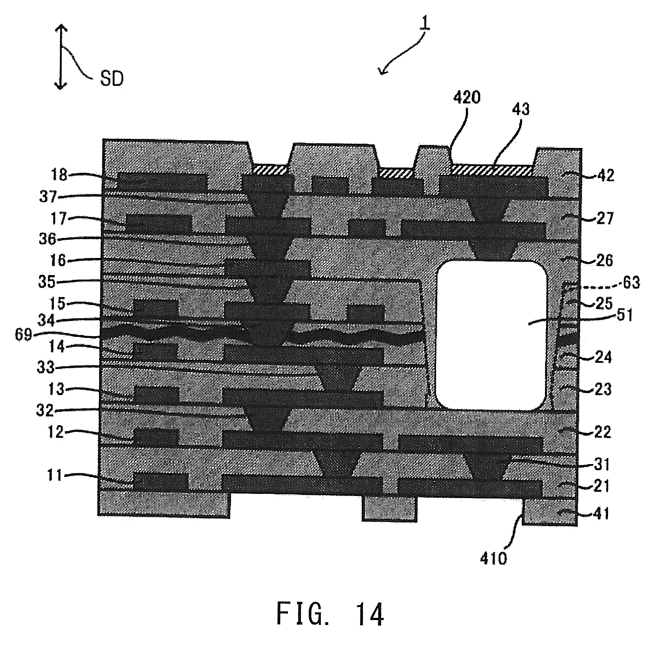

   FIG. 14 is a schematic cross-sectional view of the configuration of a multilayer wiring substrate 1 of a sixth embodiment.
[FIG. 15]

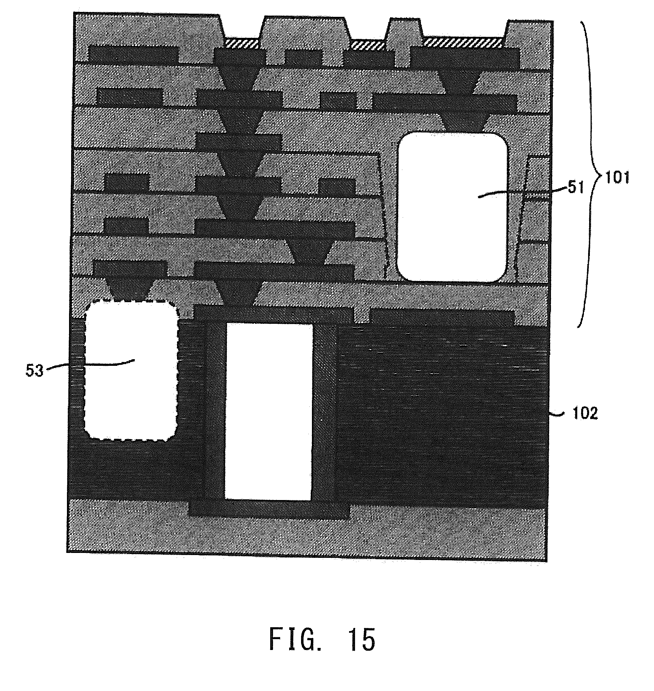

   FIG. 15 is a schematic cross-sectional view of the configuration of a multilayer wiring substrate of another embodiment.

### MODES FOR CARRYING OUT THE INVENTION

### (First embodiment)

A first embodiment of the present invention will next be described with reference to the drawings.

As shown in FIG. 1, a multilayer wiring substrate 1 of the first embodiment to which the present invention is applied includes a plurality of (eight in the present embodiment) conductor layers 11, 12, 13, 14, 15, 16, 17, and 18, and a plurality of (seven in the present embodiment; i.e., smaller by one in number than the conductor layers 11 to 18) insulation layers 21, 22, 23, 24, 25, 26, and 27, wherein the conductor layers and the insulation layers are alternately stacked in a stacking direction SD.

The insulation layers 21, 22, 23, 24, 25, 26, and 27 forming the multilayer wiring substrate 1 respectively include therein via conductors 31, 32, 33, 34, 35, 36, and 37 extending in the stacking direction SD. Thus, the conductor layers 11, 12, 13, 14, 15, 16, and 17 are electrically connected to the conductor layers 12, 13, 14, 15, 16, 17, and 18, respectively.

A solder resist layer 41 is stacked so as to cover the insulation layer 21 on the side opposite the insulation layer 22, and a solder resist layer 42 is stacked so as to cover the insulation layer 27 on the side opposite the insulation layer 26. The solder resist layers 41 and 42 respectively have openings 410 and 420 in regions in which the conductor layers 11 and 18 are provided, respectively. A Ni/Au layer 43 is stacked on the conductor layer 18 exposed through the openings 420.

An electronic component 51 is embedded in the insulation layers 23, 24, 25, and 26 forming the multilayer wiring substrate 1.

Next will be described a method for producing the multilayer wiring substrate 1 to which the present invention is applied.

As shown in FIG. 2, firstly, a support substrate 60 is provided. The support substrate 60 is a plate-like member prepared through, for example, impregnation of glass fiber with an epoxy resin, and exhibits high rigidity. In the production method according to the present embodiment, the multilayer wiring substrate 1 is produced by stacking, on opposite surfaces of the support substrate 60, the conductor layers 11 to 18, the insulation layers 21 to 27, and other components. However, in the drawings showing the production method (FIGs. 2 to 9), illustration on the lower surface side of the support substrate 60 is omitted for the sake of simplification.

A release sheet 61 is placed, via a prepreg layer (not shown) serving as an adhesive layer, on each of the opposite surfaces of the support substrate 60, and the release sheet 61 is press-bonded to the support substrate 60 by means of, for example, a vacuum heating press, to thereby stack the release sheet 61 on the substrate. The release sheet 61 is formed by stacking a metal layer 611 (a copper layer in the present embodiment) and a metal layer 612 (a copper layer in the present embodiment). Since a metal plating layer (e.g., Cr plating layer) is provided between the metal layer 611 and the metal layer 612, the metal layer 611 and the metal layer 612 can be separated from each other.

On each surface side of the support substrate 60, a film-like resin material (e.g., epoxy resin) is provided on the release sheet 61, and the resin material is cured through heating under vacuum, to thereby form the solder resist layer 41. Thus, the release sheet 61 is covered with the solder resist layer 41.

Then, on each surface side of the support substrate 60, a laser beam is applied to specific positions on the surface of the solder resist layer 41, to thereby provide openings 410 in the solder resist layer 41. Subsequently, a desmear treatment is carried out for removing smears generated in the thus-provided openings 410. Thereafter, electroless plating is carried out, to thereby form a thin electroless plating layer (a copper layer in the present embodiment) on the solder resist layer 41. Then, a specific resist pattern corresponding to the wiring pattern of the conductor layer 11 is formed on the electroless plating layer. Subsequently, electroplating is carried out, to thereby form a plating layer (a copper layer in the present embodiment) on a region which is not covered with the resist pattern. Thereafter, unwanted electroless plating layer and resist pattern are removed through etching. Thus, metal conductors 62 are formed in the openings 410, and the conductor layer 11 having a specific wiring pattern is formed.

Then, on each surface side of the support substrate 60, a film-like resin material (e.g., epoxy resin) is provided on the solder resist layer 41, and the resin material is cured through heating under vacuum, to thereby form the insulation layer 21.

Thereafter, a laser beam is applied to specific positions on the surface of the insulation layer 21, to thereby provide a plurality of via holes in the insulation layer 21. Subsequently, a desmear treatment is carried out for removing smears generated in the thus-provided via holes. Thereafter, electroless plating is carried out, to thereby form a thin electroless plating layer (a copper layer in the present embodiment) on the insulation layer 21. Then, a specific resist pattern corresponding to the wiring pattern of the conductor layer 12 is formed on the electroless plating layer. Subsequently, electroplating is carried out, to thereby form a plating layer (a copper layer in the present embodiment) on a region which is not covered with the resist pattern. Thereafter, unwanted electroless plating layer and resist pattern are removed through etching. Thus, the via conductors 31 are formed in the via holes, and the conductor layer 12 having a specific wiring pattern is formed.

Subsequently, steps similar to those for forming the insulation layer 21, the conductor layer 12, and the via conductors 31 are carried out, to thereby form, on the insulation layer 21, the insulation layers 22, 23, 24, and 25, the conductor layers 13, 14, 15, and 16, and the via conductors 32, 33, 34, and 35.

The conductor layer 13 is formed of a specific wiring pattern 131 and a depth controlling pattern 132. The conductor layers 14, 15, and 16 are provided so as not to be located above the depth controlling pattern 132 in the stacking direction SD.

Thereafter, a laser beam is applied to a specific position on the surface of the insulation layer 25, the position being located above the depth controlling pattern 132 in the stacking direction SD, to thereby provide, as shown in FIG. 3, a bottomed hole 63 which penetrates the insulation layers 25 and 24 and reaches the upper surface of the depth controlling pattern 132 in the insulation layer 23. Since the bottomed hole 63 is provided through laser processing, the bottomed hole 63 has a diameter which decreases from the upper surface of the insulation layer 25 toward the depth controlling pattern 132.

Then, as shown in FIG. 4, a specific resist pattern 64 is formed so as to cover the wiring pattern of the conductor layer 16, followed by etching. Thus, as shown in FIG. 5, the depth controlling pattern 132 is removed.

Thereafter, as shown in FIG. 6, the electronic component 51 is accommodated in the bottomed hole 63. Then, the insulation layer 26 is formed on the insulation layer 25 in the same manner as employed for formation of the insulation layers 21, 22, 23, 24, and 25. Thus, as shown in FIG. 7, the upper surface of the insulation layer 25 and the conductor layer 16 are covered with the insulation layer 26, and a space between the bottomed hole 63 and the electronic component 51 is filled with the insulation layer 26, whereby the electronic component 51 is embedded in the bottomed hole 63.

Subsequently, a laser beam is applied to specific positions on the surface of the insulation layer 26, to thereby provide, as shown in FIG. 8, a plurality of via holes 65 in the insulation layer 21. Then, a desmear treatment is carried out for removing smears generated in the via holes 65. Thereafter, electroless plating is carried out, to thereby form a thin electroless plating layer (a copper layer in the present embodiment) on the insulation layer 26. Then, a specific resist pattern corresponding to the wiring pattern of the conductor layer 17 is formed on the electroless plating layer. Subsequently, electroplating is carried out, to thereby form a plating layer (a copper layer in the present embodiment) on a region which is not covered with the resist pattern. Thereafter, unwanted electroless plating layer and resist pattern are removed through etching. Thus, as shown in FIG. 9, the via conductors 36 are formed in the via holes 65, and the conductor layer 17 having a specific wiring pattern is formed.

Subsequently, steps similar to those for forming the insulation layer 21, the conductor layer 12, and the via conductors 31 are carried out, to thereby form, on the insulation layer 26, the insulation layer 27, the conductor layer 18, and the via conductors 37.

Then, a solder resist containing an organic resin material (e.g., epoxy resin) is applied so as to cover the insulation layer 27 and the conductor layer 18, followed by patterning of the solder resist. Thus, there is formed, on the insulation layer 27, the solder resist layer 42 having the openings 420 in regions in which the conductor layer 18 is provided. Subsequently, electroless plating is carried out, to thereby form the Ni/Au layer 43 on the conductor layer 18.

Next, the metal layer 611 is removed from the metal layer 612, to thereby separate, from the support substrate 60, a layered structure 2 including, for example, the metal layer 612, and the conductor layers 11 to 18 and the insulation layers 21 to 27 stacked on the metal layer 612. Thus, two layered structures 2 are produced.

Thereafter, the metal layer 612 and the metal conductors 62 are removed through etching, to thereby produce, as shown in FIG. 1, the multilayer wiring substrate 1, which includes the insulation layer 21 having thereon the solder resist layer 41 having the openings 410 in regions in which the conductor layer 11 is provided.

The multilayer wiring substrate 1 having the aforementioned configuration includes a first layered structure including the conductor layers 13, 14, 15, and 16, and the insulation layers 23, 24, 25, and 26 including therein the via conductors 33, 34, 35, and 36 each having a diameter which decreases from the upper surface of the insulation layer toward the lower surface thereof; the electronic component 51 embedded in the first layered structure; and a second layered structure stacked on the first layered structure, and including the conductor layers 17 and 18, and the insulation layer 27 including therein the via conductors 37 each having a diameter which decreases from the upper surface of the insulation layer toward the lower surface thereof.

Thus, when the number of insulation layers forming the second layered structure is small, the embedded electronic component 51 is located in a region near the upper surface of the multilayer wiring substrate 1. Meanwhile, when the number of insulation layers forming the second layered structure is large, the embedded electronic component 51 is located in a region away from the upper surface of the multilayer wiring substrate 1.

Therefore, according to the multilayer wiring substrate 1, since a region for incorporation of the electronic component 51 is not limited to a portion near the upper surface of the multilayer wiring substrate 1, the degree of freedom of design can be improved.

The method for producing the multilayer wiring substrate 1 includes a first layered structure formation step of forming a first layered structure including the conductor layers 13, 14, 15, and 16, and the insulation layers 23, 24, 25, and 26 including therein the via conductors 33, 34, 35, and 36 each having a diameter which decreases from the upper surface of the insulation layer toward the lower surface thereof; a depth controlling pattern formation step of forming the depth controlling pattern 132 in a region in the first layered structure in which the electronic component 51 is to be embedded, the depth controlling pattern formation step being carried out during the course of the first layered structure formation step; a bottomed hole provision step of applying a laser beam via the upper surface of the first layered structure toward the depth controlling pattern 132 in the first layered structure, to thereby provide the bottomed hole 63 which extends through the first layered structure in the stacking direction SD to the depth controlling pattern 132, and which does not penetrate the depth controlling pattern 132; an accommodation step of accommodating the electronic component 51 in the bottomed hole 63; and an insulation layer stacking step of stacking the insulation layer 26 on the first layered structure after accommodation of the electronic component 51 in the bottomed hole 63.

In the method for producing the multilayer wiring substrate 1, the bottomed hole 63, which extends to the depth controlling pattern 132 but does not penetrate therethrough, is formed through application of a laser beam toward the depth controlling pattern 132 in the first layered structure. Therefore, the depth of the bottomed hole 63 can be accurately controlled with respect to the position at which the depth controlling pattern 132 is formed.

The bottomed hole 63 has a diameter which decreases downwardly. Thus, since the area of the opening of the bottomed hole 63 is larger than that of the bottom thereof, the electronic component 51 can be readily accommodated into the accommodation hole through the opening of the bottomed hole 63, and the electronic component 51 can be reliably mounted in the multilayer wiring substrate 1.

In the above-described embodiment, the depth controlling pattern 132 corresponds to the metal layer in the present invention, and the bottomed hole 63 corresponds to the accommodation hole in the present invention.

### (Second embodiment)

A second embodiment of the present invention will next be described with reference to the drawings. The following description is focused on the difference between the second embodiment and the first embodiment.

As shown in FIG. 10, the multilayer wiring substrate 1 of the second embodiment has the same configuration as that of the second embodiment, except that an electronic component 52 is additionally embedded, and depth controlling patterns 132 and 142 are additionally provided.

The electronic component 51 is embedded in the insulation layers 23, 24, 25, and 26, whereas the electronic component 52 is embedded in the insulation layers 24, 25, and 26.

The depth controlling pattern 132 is formed on the insulation layer 22. The bottomed hole 63 penetrates the insulation layer 25 and the insulation layer 24, and reaches the upper surface of the depth controlling pattern 132 in the insulation layer 23. Thus, the electronic component 51 is embedded in the insulation layers 23, 24, 25, and 26 such that the bottom of the electronic component 51 is in contact with the depth controlling pattern 132.

The depth controlling pattern 142 is formed on the insulation layer 23. A bottomed hole 66 penetrates the insulation layer 25 and reaches the upper surface of the depth controlling pattern 142 in the insulation layer 24. Thus, the electronic component 52 is embedded in the insulation layers 24, 25, and 26 such that the bottom of the electronic component 52 is in contact with the depth controlling pattern 142.

Next will be described a method for embedding the electronic components 51 and 52.

Firstly, as described in the first embodiment, the insulation layers 22, 23, 24, and 25, the conductor layers 13, 14, 15, and 16, and the via conductors 32, 33, 34, and 35 are formed on the insulation layer 21. The conductor layer 13 is formed of the specific wiring pattern 131 and the depth controlling pattern 132. The conductor layer 14 is formed of the specific wiring pattern 141 and the depth controlling pattern 142.

Thereafter, a laser beam is applied to specific positions on the surface of the insulation layer 25, the positions being located above the depth controlling patterns 132 and 142, to thereby provide the bottomed hole 63 which penetrates the insulation layers 25 and 24 and reaches the upper surface of the depth controlling pattern 132 in the insulation layer 23, and to provide the bottomed hole 66 which penetrates the insulation layer 25 and reaches the upper surface of the depth controlling pattern 142 in the insulation layer 24.

Thereafter, the electronic component 51 is accommodated in the bottomed hole 63, and the electronic component 52 is accommodated in the bottomed hole 66. Then, the insulation layer 26 is formed on the insulation layer 25. Thus, the electronic component 51 is embedded in the bottomed hole 63, and the electronic component 52 is embedded in the bottomed hole 66.

In the multilayer wiring substrate 1 having the aforementioned configuration, the depth controlling patterns 132 and 142, which are in contact with the bottoms of the electronic components 51 and 52, are located below the electronic components 51 and 52. Therefore, since heat generated in the electronic components 51 and 52 is conducted to the depth controlling patterns 132 and 142 and released to the outside of the electronic components 51 and 52, the heat release performance of the electronic components 51 and 52 can be improved.

### (Third embodiment)

A third embodiment of the present invention will next be described with reference to the drawings. The following description is focused on the difference between the third embodiment and the second embodiment.

As shown in FIG. 11, the multilayer wiring substrate 1 of the third embodiment has the same configuration as that of the second embodiment, except that the depth controlling patterns 132 and 142 are omitted.

Specifically, the electronic component 51 is embedded in the insulation layers 23, 24, 25, and 26 such that the bottom of the electronic component 51 is in contact with the insulation layer 22, and the electronic component 52 is embedded in the insulation layers 24, 25, and 26 such that the bottom of the electronic component 52 is in contact with the insulation layer 23.

The electronic components 51 and 52 are embedded in the same manner as described in the second embodiment, except that a step of removing the depth controlling patterns 132 and 142 through etching is additionally carried out after provision of the bottomed holes 63 and 65 by laser beam application.

In the multilayer wiring substrate 1 having the aforementioned configuration, the electronic components 51 and 52 are embedded in the multilayer wiring substrate 1, and the electronic components 51 and 52 are located at different positions on a plane perpendicular to the stacking direction SD. Thus, the positions of the electronic components 51 and 52 embedded in the multilayered wiring substrate 1 are not limited to a specific one position on a plane perpendicular to the stacking direction SD. Therefore, the degree of freedom of the positions of the electronic components 51 and 52 incorporated in the multilayer wiring substrate 1 can be improved.

### (Fourth embodiment)

A fourth embodiment of the present invention will next be described with reference to the drawings. The following description is focused on the difference between the fourth embodiment and the third embodiment.

As shown in FIG. 12, the multilayer wiring substrate 1 of the fourth embodiment has the same configuration as that of the third embodiment, except that the electronic component 51 is embedded in the insulation layers 22, 23, 24, and 25.

Next will be described a method for embedding the electronic components 51 and 52.

Firstly, as described in the first embodiment, the insulation layers 21, 22, 23, and 24, the conductor layers 11, 12, 13, 14, and 15, and the via conductors 31, 32, 33, and 34 are formed on the solder resist layer 41. The conductor layer 12 is formed of a specific wiring pattern 121 and a depth controlling pattern 122. The conductor layer 14 is formed of the specific wiring pattern 141 and the depth controlling pattern 142.

Thereafter, a laser beam is applied to a specific position on the surface of the insulation layer 25, the position being located above the depth controlling pattern 122, to thereby provide a bottomed hole 67 which penetrates the insulation layers 24 and 23 and reaches the upper surface of the depth controlling pattern 122 in the insulation layer 22.

Then, a specific resist pattern is formed so as to cover the wiring pattern of the conductor layer 15, followed by etching, to thereby remove the depth controlling pattern 122.

Thereafter, the electronic component 51 is accommodated in the bottomed hole 67. Then, the insulation layer 25 is formed on the insulation layer 24. Thus, the upper surface of the insulation layer 24 and the conductor layer 15 are covered with the insulation layer 25, and a space between the bottomed hole 67 and the electronic component 51 is filled with the insulation layer 25, whereby the electronic component 51 is embedded in the bottomed hole 67. Then, the via conductors 35 are formed in the insulation layer 25, and the conductor layer 16 is formed on the insulation layer 25.

Thereafter, a laser beam is applied to a specific position on the surface of the insulation layer 25, the position being located above the depth controlling pattern 142, to thereby provide a bottomed hole 66 which penetrates the insulation layer 25 and reaches the upper surface of the depth controlling pattern 142 in the insulation layer 24.

Then, a specific resist pattern is formed so as to cover the wiring pattern of the conductor layer 16, followed by etching, to thereby remove the depth controlling pattern 142.

Thereafter, the electronic component 52 is accommodated in the bottomed hole 66. Then, the insulation layer 26 is formed on the insulation layer 25. Thus, the upper surface of the insulation layer 25 and the conductor layer 16 are covered with the insulation layer 26, and a space between the bottomed hole 66 and the electronic component 52 is filled with the insulation layer 26, whereby the electronic component 52 is embedded in the bottomed hole 66. The subsequent steps are carried out in the same manner as described in the first embodiment.

In the multilayer wiring substrate 1 having the aforementioned configuration, the electronic component 51 is embedded in the insulation layers 22 and 23 in which the electronic component 52 is not embedded. Therefore, since a wire can be formed in the insulation layers 22 and 23 (in which the electronic component 51 is embedded) at a region facing the electronic component 52 in the stacking direction SD, wiring density can be improved in the insulation layers 22 and 23 in which the electronic component 51 is embedded.

### (Fifth embodiment)

A fifth embodiment of the present invention will next be described with reference to the drawings. The following description is focused on the difference between the fifth embodiment and the first embodiment.

As shown in FIG. 13, the multilayer wiring substrate 1 of the fifth embodiment has the same configuration as that of the first embodiment, except that the height of the electronic component 51 is varied, and a via conductor 68 is provided instead of the via conductor 36 for connecting the electronic component 51 to the conductor layer 17.

The height (length in the stacking direction SD) of the electronic component 51 is smaller than that of the bottomed hole 63. Thus, in the first embodiment, the electronic component 51 is embedded in the insulation layers 23, 24, 25, and 26, whereas in the fifth embodiment, the electronic component 51 is embedded in the insulation layers 23, 24, and 25.

The via conductor 68 electrically connects the electronic component 51 to the conductor layer 17, and the length of the via conductor 68 in the stacking direction SD is larger than that of the insulation layer 26 through which the via conductor 68 penetrates.

Therefore, the via conductor 68 is formed through a process in which the insulation layer 26 is stacked on the insulation layer 25, and then a via hole is provided so as to penetrate the insulation layer 26, to extend in the insulation layer 25, and to reach the electronic component 51. That is, formation of the via conductor 68 does not require a process in which the via conductor 35 is formed after stacking of the insulation layer 25, and then the via conductor 36 is formed after stacking of the insulation layer 26. Thus, the process of forming the via conductor 68 can be simplified.

### (Sixth embodiment)

A sixth embodiment of the present invention will next be described with reference to the drawings. The following description is focused on the difference between the sixth embodiment and the first embodiment.

As shown in FIG. 14, the multilayer wiring substrate 1 of the sixth embodiment has the same configuration as that of the first embodiment, except that a glass fiber layer 69 is provided in the insulation layer 24.

Therefore, the bottomed hole 63 and the via conductor 34 are provided so as to penetrate the glass fiber layer 69.

In the multilayer wiring substrate 1 having the aforementioned configuration, the glass fiber layer 69 is provided in the insulation layer 24, and the electronic component 51 is embedded so as to penetrate the glass fiber layer 69. Thus, the rigidity of a portion in which the electronic component 51 is embedded can be enhanced in the multilayer wiring substrate 1.

Although specific embodiments of the present invention have been described above, the present invention is not limited to the embodiments, and various other embodiments may be carried out so long as they fall within the technical scope of the invention.

In each of the above-described embodiments, the electronic component is embedded in the multilayer wiring substrate. However, for example, as shown in FIG. 15, an electronic component 53 may be embedded in a core substrate 102 which supports a multilayer wiring substrate 101 in which an electronic component 51 is embedded.

### DESCRIPTION OF REFERENCE NUMERALS

1: multilayer wiring substrate
11, 12, 13, 14, 15, 16, 17, 18: conductor layer
21, 22, 23, 24, 25, 26, 27: insulation layer
31, 32, 33, 34, 35, 36, 37, 68: via conductor
51, 52: electronic component
63, 66, 67: bottomed hole
69: glass fiber layer
132, 142: depth controlling pattern

## Claims

1. A multilayer wiring substrate comprising a plurality of insulation layers and a plurality of conductor layers, the insulation layers and the conductor layers being alternately stacked, and a via conductor formed in each insulation layer for electrically connecting conductor layers formed on upper and lower surfaces of the insulation layer, the multilayer wiring substrate being **characterized by** comprising:
a first layered structure including a plurality of conductor layers, and a plurality of insulation layers each including therein a via conductor having a diameter which decreases from the upper surface of the insulation layer toward the lower surface thereof;
an electronic component embedded in the first layered structure; and
a second layered structure stacked on the first layered structure, and including at least one conductor layer, and at least one insulation layer including therein a via conductor having a diameter which decreases from the upper surface of the insulation layer toward the lower surface thereof.

2. A multilayer wiring substrate according to claim 1, wherein the first layered structure includes a metal layer which is formed below the electronic component so as to be in contact with a lower portion of the electronic component.

3. A multilayer wiring substrate according to claim 1 or 2, wherein a plurality of the electronic components are embedded in the first layered structure, and the electronic components are located at different positions on a plane perpendicular to a stacking direction of the first layered structure.

4. A multilayer wiring substrate according to claim 3, wherein
one electronic component of the electronic components embedded in the first layered structure is defined as a first electronic component;
another electronic component different from the first electronic component is defined as a second electronic component;
among the insulation layers forming the first layered structure, an insulation layer which does not have the first electronic component embedded therein is defined as a non-embedded insulation layer; and
the second electronic component is also embedded in the non-embedded insulation layer.

5. A multilayer wiring substrate according to any one of claims 1 to 4, wherein the via conductor to an upper portion of the electronic component has a length in the stacking direction of the first layered structure greater than that of the insulation layer through which the via conductor penetrates.

6. A multilayer wiring substrate according to any one of claims 1 to 5, wherein a glass fiber layer is provided in the first layered structure, and the electronic component is embedded so as to penetrate the glass fiber layer.

7. A multilayer wiring substrate according to any one of claims 1 to 6, wherein the first layered structure has therein an accommodation hole for accommodating the electronic component in the first layered structure, the accommodation hole being provided before embedment of the electronic component in the first layered structure, and the accommodation hole has a diameter which decreases downwardly.

8. A method for producing a multilayer wiring substrate comprising a plurality of insulation layers and a plurality of conductor layers, the insulation layers and the conductor layers being alternately stacked, and a via conductor formed in each insulation layer for electrically connecting conductor layers formed on upper and lower surfaces of the insulation layer, the method being **characterized by** comprising
a first layered structure formation step of forming a first layered structure including a plurality of conductor layers, and a plurality of insulation layers each including therein a via conductor having a diameter which decreases from the upper surface of the insulation layer toward the lower surface thereof;
a metal layer formation step of forming a metal layer in a region in the first layered structure in which an electronic component is to be embedded, the metal layer formation step being carried out during the course of the first layered structure formation step;
an accommodation hole provision step of applying a laser beam via an upper surface of the first layered structure toward the metal layer in the first layered structure, to thereby provide an accommodation hole which extends in a stacking direction of the first layered structure to the metal layer, and which does not penetrate the metal layer;
an accommodation step of accommodating an electronic component in the accommodation hole; and
an insulation layer stacking step of stacking an insulation layer on the first layered structure after accommodation of the electronic component in the accommodation hole.

9. A method for producing a multilayer wiring substrate according to claim 8, which comprises a removal step of removing the metal layer after provision of the accommodation hole and before accommodation of the electronic component in the accommodation hole.

## Amended claims

### Amended claims under Art. 19.1 PCT

**1.** A multilayer wiring substrate comprising a plurality of insulation layers and a plurality of conductor layers, the insulation layers and the conductor layers being alternately stacked, and a via conductor formed in each insulation layer for electrically connecting conductor layers formed on upper and lower surfaces of the insulation layer, the multilayer wiring substrate being **characterized by** comprising:
a first layered structure including a plurality of conductor layers, and a plurality of insulation layers each including therein a via conductor having a diameter which decreases from the upper surface of the insulation layer toward the lower surface thereof;
an electronic component embedded in the first layered structure; and
a second layered structure stacked on the first layered structure, and including at least one conductor layer, and at least one insulation layer including therein a via conductor having a diameter which decreases from the upper surface of the insulation layer toward the lower surface thereof.

**2.** A multilayer wiring substrate according to claim 1, wherein the first layered structure includes a metal layer which is formed below the electronic component so as to be in contact with a lower portion of the electronic component.

**3.** A multilayer wiring substrate according to claim 1 or 2, wherein a plurality of the electronic components are embedded in the first layered structure, and the electronic components are located at different positions on a plane perpendicular to a stacking direction of the first layered structure.

**4.** A multilayer wiring substrate according to claim 3, wherein
one electronic component of the electronic components embedded in the first layered structure is defined as a first electronic component;
another electronic component different from the first electronic component is defined as a second electronic component;
among the insulation layers forming the first layered structure, an insulation layer which does not have the first electronic component embedded therein is defined as a non-embedded insulation layer; and
the second electronic component is also embedded in the non-embedded insulation layer.

**5.** (Amended) A multilayer wiring substrate according to any one of claims 1 to 4, wherein the via conductor to an upper portion of the electronic component has a length in the stacking direction of the first layered structure greater than that of a portion of the insulation layer through which the via conductor penetrates, the portion being not located above the electronic component.

**6.** A multilayer wiring substrate according to any one of claims 1 to 5, wherein a glass fiber layer is provided in the first layered structure, and the electronic component is embedded so as to penetrate the glass fiber layer.

**7.** A multilayer wiring substrate according to any one of claims 1 to 6, wherein the first layered structure has therein an accommodation hole for accommodating the electronic component in the first layered structure, the accommodation hole being provided before embedment of the electronic component in the first layered structure, and the accommodation hole has a diameter which decreases downwardly.

**8.** A method for producing a multilayer wiring substrate comprising a plurality of insulation layers and a plurality of conductor layers, the insulation layers and the conductor layers being alternately stacked, and a via conductor formed in each insulation layer for electrically connecting conductor layers formed on upper and lower surfaces of the insulation layer, the method being **characterized by** comprising
a first layered structure formation step of forming a first layered structure including a plurality of conductor layers, and a plurality of insulation layers each including therein a via conductor having a diameter which decreases from the upper surface of the insulation layer toward the lower surface thereof;
a metal layer formation step of forming a metal layer in a region in the first layered structure in which an electronic component is to be embedded, the metal layer formation step being carried out during the course of the first layered structure formation step;
an accommodation hole provision step of applying a laser beam via an upper surface of the first layered structure toward the metal layer in the first layered structure, to thereby provide an accommodation hole which extends in a stacking direction of the first layered structure to the metal layer, and which does not penetrate the metal layer;
an accommodation step of accommodating an electronic component in the accommodation hole; and
an insulation layer stacking step of stacking an insulation layer on the first layered structure after accommodation of the electronic component in the accommodation hole.

**9.** A method for producing a multilayer wiring substrate according to claim 8, which comprises a removal step of removing the metal layer after provision of the accommodation hole and before accommodation of the electronic component in the accommodation hole.
